**Europäisches Patentamt**

(19) **European Patent Office**

**Office européen des brevets**

(11) Publication number : **0 470 784 A2**

## (12) EUROPEAN PATENT APPLICATION

(21) Application number : **91307148.6**

(22) Date of filing : **02.08.91**

(51) Int. Cl.[5] : **C23C 16/04, C23C 16/48**

(30) Priority : **10.08.90 US 565096**

(43) Date of publication of application :
**12.02.92 Bulletin 92/07**

(84) Designated Contracting States :
**DE FR GB**

(71) Applicant : **MOTOROLA INC.**
**Motorola Center 1303 Algonquin Rd.**
**Schaumburg Illinois 60196 (US)**

(72) Inventor : **Keller, Edward M.**
**2052 E. Fremont Drive**
**Tempe, Arizona 85282 (US)**

(74) Representative : **Lupton, Frederick et al**
**Motorola European Intellectual Property**
**Operations Seal House Seal Road**
**Basingstoke, Hants RG21 1NQ (GB)**

(54) **Method for selectively depositing a thin film.**

(57)   An apparatus and method for selectively depositing a thin film by projecting geometric features on a semiconductor wafer. Semiconductor wafer (17) is mounted in a chemical vapor deposition chamber (18) that has a projection means. A gas species is injected though gas input (19).and travels across wafer (17) to exhaust port (21). The gas species has a low photodissociation energy level so that when exposed to an ultraviolet light source deposition on the semiconductor wafer (17) takes place.

EP 0 470 784 A2

**FIG. 1**

Field of the Invention

This invention relates, in general, to manufacturing semiconductor devices, and more particularly, to the generation of patterned thin films on a semiconductor device.

Background of the Invention

Formation of geometric patterns is an integral part of manufacturing semiconductor devices. The patterns that are generated define physical components of devices that are to be manufactured. The generation of patterns on semiconductor wafer materials is usually divided into three major steps: deposition, photolithography, and etching.

Deposition is a process in which a film is applied onto a surface. Film types that are commonly used in manufacturing of semiconductors range from insulators to conductors. Generally, each kind of film that is deposited requires a different piece of equipment and a wide variety of process conditions.

Photolithography is a process of defining patterns in a photo sensitive material, know as photoresist, by projecting images that are desired into the body of a photoresist film. The photolithography process is a very complicated set of conditions and processes but, can be broken down into three major steps or processes. First, is an application of photoresist material to the surface of a semiconductor wafer. Generally, this process is achieved by applying a measured amount of liquid photoresist material in the center of a semiconductor wafer. The semiconductor wafer is then spun at high RPM to produce a uniform film of photoresist over the entire wafer surface. The wafer is then heated slightly, which drives off some volatile solvents, gels the film, and prepares it for an image projection step. This array of processes and conditions is accomplished by a complicated piece of equipment called a wafer coater. Second, is projecting desired images or patterns onto the photoresist coated wafer. Projection of these images can be achieved by a variety of cameras that are commercially available. Generally, these cameras project desired images or patterns by illuminating a reticle image that casts very sharp patterns of light and dark areas. In positive photoresist systems, exposure to light causes chemical reactions to take place in the photoresist, which changes the solubility of the exposed photoresist in an aqueous base. Therefore, areas that are illuminated are exposed and areas that are in darkness are not exposed. Third, is development of images that have been exposed from the projection step. Images that have been projected into the photoresist film are made into three dimensional patterns in the photoresist film that has been applied to the wafer. This step is accomplished by taking advantage of the solubility differences between exposed photoresist and non-exposed photoresist. Application of an aqueous base to exposed areas of photoresist dissolves the film away whereas, application of the aqueous base to unexposed photoresist does not dissolve the film away. Completion of the development process leaves three dimensional patterns of unexposed photoresist on the wafer. The patterns formed by the photoresist are now ready for transferring or etching into the underlying deposited film. Developing photoresist can be done with a number of different processes and equipment sets.

Etching is a process of transferring a photoresist pattern to an underlying film. Etching these patterns is accomplished either by chemical or physical methods or a combination of the two. Etching also requires the use of different pieces of equipment in which a wide variety of chemistries is used.

It can be seen that the conventional process of pattern generation uses a large number of steps, equipment types, and processes. Each processing step, and use of expensive equipment incurs a cost to a finished product. Additionally, many different pieces of equipment occupy valuable factory floor space which also adds cost to the finished product. It should be evident that producing patterns is a very costly and labor intensive process. Therefore, a method and apparatus that would substantially reduce and consolidate the number of steps and reduce the number of pieces of equipment is highly desirable.

Summary of the Invention

Various aspects of the invention are set forth in the claims. The invention provides an apparatus and method for selectively depositing a thin film by projecting geometric features on a semiconductor wafer. At least in the preferred embodiment, the semiconductor wafer is mounted in a chemical vapor deposition chamber that has a projection means. A gas species that is flowing though the chemical vapor deposition chamber has a low photodissociation energy level. Directing an ultraviolet light or equivalent energy source though the projection means to generate a predetermined geometric pattern on the semiconductor wafer so that at least a patterned monomolecular film is produced. This monomolecular film can then be used to grow a thicker film, if desired.

Brief Description of the Drawings

FIG. 1 is a schematic cross-sectional view of a chemical vapor deposition reactor with a projection means; and
FIG. 2 pictorially illustrates a cluster tool system.

Detailed Description of the Drawings

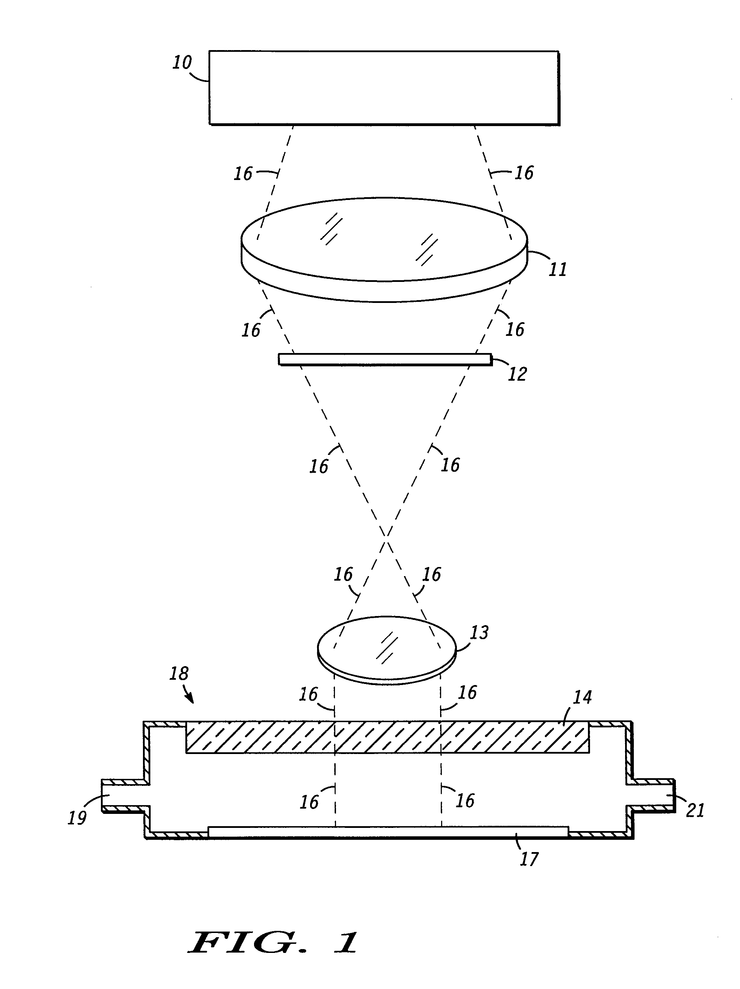

A cross-sectional side view of a chemical vapor deposition reactor with a projection means is schematically illustrated in FIG. 1. Ultraviolet light source 10 is shown as a modular block. Ultraviolet light source 10 provides illumination and radiant energy to project an image on wafer 17. Ultraviolet light source 10 can contain a variety of mirrors, lamps, and filters. Generally, though a mirror is positioned so as to be able to reflect radiation from a lamp and direct its radiation though a filter. Lamps are usually Mercury Arc that emit several lines of intense wave lengths in the ultraviolet radiation range. Filtering radiation allows for selection of a specific wave length of light. Dotted lines 16 represent the light path of radiation as it passes though various elements of a projection system. Radiation from ultraviolet light source 10 is directed to condensing lens system 11. Condensing lens system 11 can be composed of a multitude of lens depending upon requirements that are optically necessary. Condensing lens system 11 concentrates radiation from ultraviolet light source 10, as well as, ensuring that an even illumination across reticle or mask 12 is accomplished. Reticle or mask 12 is where geometric patterns that are desired to be projected are kept. Reticle or mask 12 is manufactured by a well known photolithographic process. Reticle or mask 12 is generally made of optically clear quartz plates or the like. On one side of reticle or mask 12 there is a pattern depicted in chrome. Radiation from condensing lens system 11 shines though the reticle or mask 12 to generate a pattern of light and dark spaces that correspond to a pattern depicted in chrome on reticle or mask 12. This pattern then illuminates reduction lens system 13. Reduction lens system 13 can be composed of many different lens elements. Reduction lens system 13 reduces the pattern generated from reticle or mask 12 to desired size. Reduction lens that are most commonly used in manufacturing semiconductor devices are 10X and 5X. Therefore, in the case of a 10X reduction lens a ten micron line on reticle or mask 12 will yield a one micron line after passing though reduction lens system 13. It should be understood that other sources of imaging apparatus could be utilized to project images such as a Perkin Elmer scanning system, a laser direct write system, an Electron Beam "E Beam" direct write system, or the like.

The image that passes though reduction lens system 13 now passes though window 14. Window 14 is an interface between the optical system and a chemical vapor deposition system. Window 14 is composed of an ultraviolet transparent material such as quartz or the like, so that transmission of patterned radiation though window 14 can be directed to wafer 17 without loss of intensity or resolution. Window 14 is part of a chemical vapor deposition reactor or chamber 18 and is connected to chemical vapor deposition reactor 18 in such a manner that either low or high pressure chemistry may be used in reactor 18. The selection of high or low pressure chemistry is dependent upon chemistry of gases that are used. Radiation that passes though window 14 and though chemical vapor deposition reactor 18 ultimately strikes wafer 17 mounted in chemical vapor deposition reactor 18. Gas inject port 19 allows for the entrance of a reactive gas into the chamber of chemical vapor deposition reactor 18. It should be understood that more than one gas could be injected into chemical vapor deposition body 18 from gas inject port 19. Once the gas is injected into chemical vapor deposition reactor 18 it can be handled either dynamically or statically. Dynamically, injected gas travels across wafer 17. As gas travels across wafer 17 energy from the projection system is sufficient to cause at least a monomolecular deposition on wafer 17. Deposition is caused by either the localized thermal heating of wafer 17 itself or by gas phase nucleation and proximity deposition. Unused gases are expelled though exhaust port 21. The deposition on wafer 17 which is created by projection of radiation from the projection system is a duplication of the pattern on reticle or mask 12. Statically, the gas enters chemical vapor deposition reactor 18. When a predetermined process parameter is reached such as pressure, flow rate, temperature, time, or the like is reached suitable valving closes and holds the gas in chemical vapor deposition reactor 18. Energy from projection means is then directed onto wafer 17. The energy from the projection means is sufficient to cause deposition of at least a selective monolayer of film on wafer 17. Unused gases are then expelled though exhaust port 21.

The invention utilizes a type of gas that is customized so that when a radiation source is projected onto the wafer there is sufficient energy to dissociate the gas into at least two parts. One part is deposited on the wafer surface in a predetermined pattern and the other is exhausted though port 21. The deposited portion of the gas forms the geometric patterns that are required to build geometric features such as metal interconnect lines, dielectric isolation features, semiconductor features, or the like. Gases that are suitable for use in this invention are volatile organometallics. By way of example, copper (I) species such as amines, phosphites, arsines, carbonyls, alkyls, diketonates, or the like may be used to practice this invention. It should be understood that the gas examples are not intended to limit this invention and that other gas configurations are possible. Radiation sources can be of many different kinds such as ultraviolet, electron beam, Laser, or the like. Preferably, the gas is a low activation energy photodissociation gas. Photodissociation is dissociation caused by a patterned light leam or a direct write system such as an E - beam system, or the like. It is well known that a direct write system does not require a mask or reticle such as illustrated in FIG. 1.

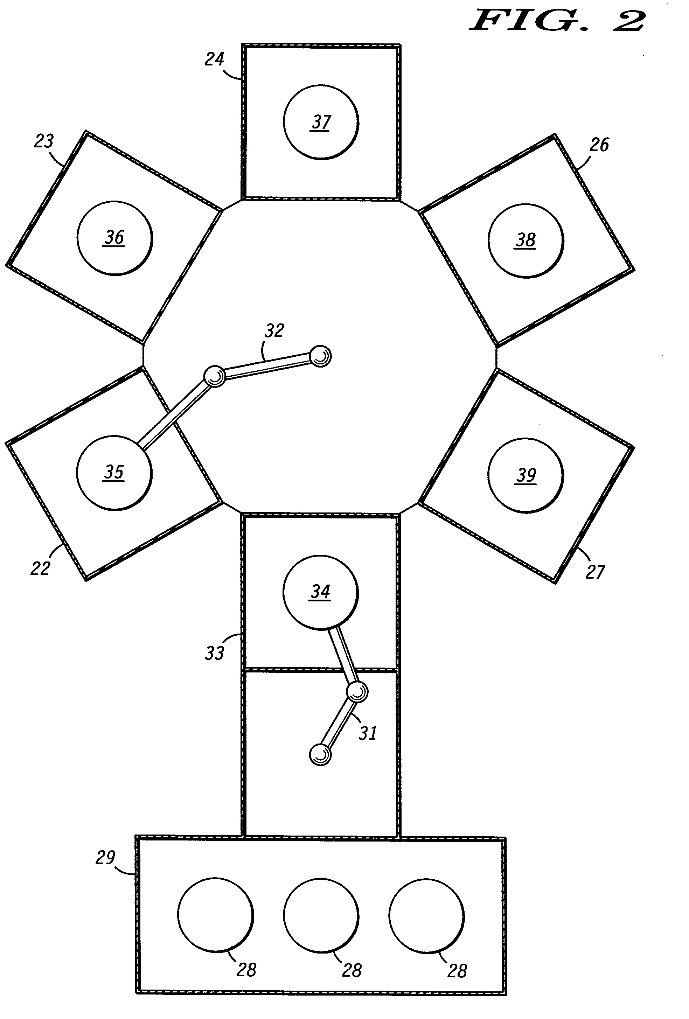

FIG. 2 pictorially illustrates one embodiment of the present invention in a multi-chamber cluster tool arrangement. Cluster tools are highly automated and it should be understood that processes and movement of wafers are controlled by a computer managing system. Cluster tools also offer an advantage of being able to keep wafers clean and under vacuum during processing and wafer movement procedures. Wafers are introduced to wafer storage chamber 29. Wafer storage chamber 29 can be evacuated or not depending upon specific uses. Wafer storage chamber 29 also must have room for at least one cassette 28, but can have more than one cassette as is shown in FIG. 2. Wafer cassette 28 is a storage device which holds wafers. Generally, cassettes are manufactured so that individual wafers are kept in separate slots with a specified amount of space between them. This space is sufficient so that one stored wafer will not rub against another stored wafer and create particles. It also allows sufficient space for easy access by a robot arm 31 so that wafers may be retrieved and returned for processing. Wafers are retrieved from cassettes 28 from wafer storage 29 and moved to vacuum wafer storage 33. Movement of wafers from cassette 28 to vacuum wafer storage 29 is accomplished by robot arm 31. Once wafers are in vacuum storage 33 they are then capable of being moved to any one of the available reactors or chambers. Movement from wafer storage 33 to any of the available reactors is accomplished by a robot arm 32. It should be understood that robot arm 31 and robot arm 32 need to be in communication with each other so as to avoid wafer handling problems. A typical process moves wafer 34 from vacuum wafer storage 33 to pre-treatment reactor 22. Pre-treatment reactor 22 cleans and predisposes wafer 35 for chemical vapor deposition lithographic (CVD-Lith) reactor 23. Predisposing wafer 35 results in a treatment of wafer surface 35 in a manner so as to facilitate pattern deposition on wafer 36 in CVD-Lith reactor 23.

Reaction mechanisms in CVD Lith reactor 23 are generally describe as photodissociation reactions. Generally, photodissociation reactions are chemical reactions that occur upon exposure to light that causes separation of a molecule into at least two parts. It should be understood that this reaction is dependent upon wavelength, energy input and specific gases that are used. Further, it should be understood that gases can be tailored to dissociate at specific wavelengths and energy levels.

Robot arm 32 retrieves wafer 35 from pre-treatment reactor 22 after wafer 35 has been processed and moves wafer 35 to CVD-Lith reactor 23. CVD-Lith reactor 23 selectively deposits at least a monomolecular film on wafer 36. CVD-Lith reactor 23 is shown in one embodiment in more detail in FIG. 1. It should be understood that this is only one embodiment and others can be used. Wafer 36 is now moved into a chemical vapor deposition (CVD) chamber or deposition reactor 24 or deposition reactor 26 for selective deposition onto the monomolecular layer provided by CVD-Lith reactor 23. Once full thickness of selective material is achieved in deposition reactor 24 or deposition chamber 26 wafer 37 or wafer 38 is removed by robot arm 32 and placed in vacuum chamber 33. Completed wafer 34 is then moved back to cassettes 28.

In another process flow after desired thickness has been achieved on wafer 37 in chamber 24 Wafer 37 is then moved to deposition reactor 26 for a deposition of a different film such as nitride, oxide or the like. Wafer 38 is then moved to reactor 27 where surface modification of wafer 39 can be done. Wafer 39 is then moved back to deposition reactor 26 for further deposition. Wafer 38 can then either be moved to reactor 27 for further surface modification sequencing or can be removed from the system though vacuum chamber 33. It should be understood that cluster tools lend themselves to integrated processing, which makes it possible to deposit or etch a wide variety of film types.

In another embodiment, when wafer 34 is in CVD-Lith reactor 23 for CVD-Lith selective deposition, the deposition is made to full thickness. Wafer 36 is then moved on for further processing.

The geometric features and patterns that are derived can be conductive lines or other portions of semiconductor devices depending upon the gases used during the chemical vapor deposition lithographic step.

It will be understood that the described reactors are very modular in nature. This modularity allows for absolute freedom to located reactors in any position around the cluster tool. It will still be further understood that wafers can be processed in and out of various reactors as many times as is desired.

By now, it should be appreciated that there has been provided a novel apparatus and method for manufacturing geometric features on a semiconductor wafer. It should also be appreciated that this approach greatly reduces the number of steps that are required to pattern semiconductor materials, as well as, offering a defect free controlled environment.

## Claims

1. A method for selectively depositing a thin film by projecting geometric features onto a semiconductor wafer which comprises:

   mounting the semiconductor wafer (17) in a chemical vapor deposition reactor (18) that has a projection means;

   flowing a low energy photodissociation gas species into the chemical vapor deposition reactor (18); and

   directing an ultraviolet light source (10) though the projection means to generate a predetermined geometric pattern on the semiconductor wafer (17) so that at least a patterned monomolecular film is produced.

2. The method of claim 1 further including treating the semiconductor wafer in a pre-conditioning chamber to enhance the deposition of the thin film in the exposed areas.

3. The method of claim 1 further including using a chemical vapor deposition chamber for enhancing the monomolecular film to full thickness by selectively depositing on the monomolecular film.

4. A method of selectively depositing a thin film by projecting images on a wafer (17) comprising:
   mounting the wafer (17) in a chemical vapor deposition reactor (18) that has an ultraviolet transparent window (14);
   flowing a gas with a low energy of activation for photodissociation into the chemical vapor deposition reactor (18);
   directing an ultraviolet light source (10) though the projection means (14) to expose an area of the wafer (17) so that at least a monomolecular film is produced, and
   flowing a gas that reacts selectively with the monomolecular film to grow the thin film to a predetermined thickness.

5. An apparatus for selectively depositing a thin film by projecting a geometric pattern onto a semiconductor wafer (17) which comprises:
   a chemical vapor deposition reactor (18) that has a geometric projecting means and means for receiving the semiconductor wafer (17); and
   gas flow means for injecting low activation energy photodissociation gas into the chemical vapor deposition reactor (18).

6. The apparatus of claim 5 further including a pre-conditioning chamber to pretreat the wafer prior for the enhancement of deposition of the thin film in the exposed areas.

7. A method for selectively depositing a metal film on a wafer surface comprising the steps of:
   placing a wafer (17) in a chemical vapor deposition reactor (18) having projection means;
   introducing a gas species having a relatively low activation energy into said reactor (18); and
   projecting a metalization pattern onto a surface of said wafer (17) with said projection means, said patterned projection having an energy capable of activating said gas species so that it selectively deposits on said wafer (17) surface in a so lid state.

8. A method of providing conductive lines on a semiconductor wafer comprising:
   providing a low energy light source (10);
   placing a semiconductor wafer (17) in a chemical vapor deposition reactor (18);
   providing a gas which is reactive to the low energy light source (10) into the reactor (18); and
   directing a light beam from the low energy light source (10) through a pattern generating means onto the semiconductor wafer (17) to provide the conductive lines from elements released by the gas caused by the light beam.

9. A method for selectively depositing a thin film by projecting geometric features onto a semiconductor wafer which comprises:
   mounting the semiconductor wafer (17) in a chemical vapor deposition lithographic reactor (18);
   injecting a low activation energy photodissociation gas into the chemical vapor deposition lithographic reactor (18);
   sealing the chemical vapor deposition lithographic reactor to hold the low activation photodissociation energy gas in the chemical vapor deposition lithographic reactor (18); and
   directing an energy source from projecting means though the low activation energy photodissociation gas to produce at least a monolayer of selective film on the semiconductor wafer (17).

10

16 16

11

16 16

12

16 16

16 16

13

18

16 16

14

19

16 16

17

21

# FIG. 1

*FIG. 2*